(19)

Europäisches
Patentamt
European
Patent Office
Office européen
des brevets

(11) **EP 1 932 940 A1**

(12) **EUROPEAN PATENT APPLICATION**

(43) Date of publication:
**18.06.2008 Bulletin 2008/25**

(51) Int Cl.:
*C23C 14/34* (2006.01)   *C22C 21/00* (2006.01)

(21) Application number: **07022151.0**

(22) Date of filing: **14.11.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **20.11.2006 JP 2006313505**

(71) Applicants:
• **KABUSHIKI KAISHA KOBE SEIKO SHO Kobe-shi,**
**Hyogo 651-8585 (JP)**
• **Kobelco Research Institute , Inc.**
**Kobe-shi**
**Hyogo 651-0073 (JP)**

(72) Inventors:
• **Takagi, Katsutoshi**
**Takasago-shi,**
**Hyogo 676-8670 (JP)**

• **Ehira, Masaya**
**Takasago-shi,**
**Hyogo 676-8670 (JP)**
• **Kugimiya, Toshihiro**
**Takasago-shi,**
**Hyogo 676-8670 (JP)**
• **Yoneda, Yoichiro**
**Takasago-shi,**
**Hyogo 676-8670 (JP)**
• **Gotou, Hiroshi c/o Kobe Corporate Research Laboratories in Kobe Steel Ltd.**
**Kobe-shi,**
**Hyogo 651-2271 (JP)**

(74) Representative: **Müller-Boré & Partner**
**Patentanwälte**
**Grafinger Strasse 2**
**81671 München (DE)**

(54) **AL-based alloy sputtering target and process for producing the same**

(57)    The present invention relates to an Al-based alloy sputtering target, comprising Ni in an amount of 0.05 to 10 atomic percent, wherein the Al-based alloy sputtering target satisfies: (1) that a ratio of a P value to a total area of a sputtering surface is 70% or more, wherein the P value indicates a total of area fractions of <001> $\pm$ 15°, <011> $\pm$ 15°, <111> $\pm$ 15° and <311> $\pm$ 15°; (2) that a ratio of the area fraction of <011> $\pm$ 15° to the P value is 30% or more; and (3) that a ratio of the area fraction of <111> $\pm$ 15° to the P value is 10% or less, when crystallographic orientations <001>, <011>, <111> and <311> in a normal line direction to a sputtering surface of the Al-based alloy sputtering target are observed in accordance with the electron backscatter diffraction pattern method.

*FIG. 1*

**Description**

The present invention relates to an Al-based alloy sputtering target containing Ni and a process for producing the same. In detail, it relates to a Ni-containing Al-based alloy sputtering target in which crystallographic orientations in a normal line direction of a sputtering surface are controlled.

An Al-based alloy, being low in the electrical resistivity and easy to process, is widely used in a field of flat panel displays (FPD) such as liquid crystal displays (LCD), plasma display panels (PDP), electroluminescent displays (ELD) and field emission displays (FED) and is used as materials for interconnection films, electrode films and reflective electrode films.

For instance, an active matrix type liquid crystal display includes a thin film transistor (TFT) that is a switching element, a pixel electrode made of a conductive oxide film and a TFT substrate having an interconnection containing a scanning line and a signal line and the scanning line, the signal line being electrically connected to the pixel electrode. As an interconnection material that constitutes the scanning line and signal line, generally, thin films of a pure Al or an Al-Nd alloy are used. However, when the thin films are directly connected to the pixel electrode, insulating aluminum oxide is formed at an interface to increase the electrical resistance. Accordingly, so far, a barrier metal layer made of a refractory metal such as Mo, Cr, Ti or W has been disposed between the Al interconnection material and the pixel electrode to reduce the electrical resistance.

However, in a method of interposing a barrier metal layer such as mentioned above, there is a problem in that a production process becomes troublesome to be high in the production cost.

In this connection, there has been proposed, as a technology that, without interposing a barrier metal layer, enables to directly connect an electroconductive oxide film that constitutes a pixel electrode and an interconnection material (direct contact technology), a method in which as an interconnection material a film of an Al-Ni alloy or an Al-Ni alloy further containing a rare earth element such as Nd or Y is used (see, JP-A-2004-214606). When Al-Ni alloy is used, at an interface, an electroconductive Ni-containing precipitates are formed to suppress insulating aluminum oxide from generating; accordingly, the electrical resistance can be suppressed low. Furthermore, when Al-Ni-rare earth element alloy is used, the heat resistance can be further improved.

Now, when an Al-based alloy thin film is formed, in general, a sputtering method that uses a sputtering target has been adopted. According to a sputtering method, plasma discharge is generated between a substrate and a sputtering target (target material) constituted of a thin film material, a gas ionized by the plasma discharge is brought into collision with the target material to knock out atoms of the target material to deposit on the substrate to produce a thin film. The sputtering method, different from a vacuum deposition method and an arc ion plating method (AIP), has an advantage in that a thin film having a composition same as that of the target material can be formed. In particular, an Al-based alloy thin film deposited by use of the sputtering method can dissolve an alloy element such as Nd that cannot be dissolved in an equilibrium state and thereby can exert excellent performance as a thin film; accordingly, the sputtering method is an industrially effective thin film producing method and a development of a sputtering target material that is a raw material thereof has been forwarded.

Recently, in order to cope with the productivity enlargement of FPDs, a depositing rate at the sputtering tends to be increased more than ever. In order to increase the depositing rate, the sputtering power can be most conveniently increased. However, when the sputtering power is increased, sputtering defects such as arching (irregular discharge) and splash (fine melt particles) are caused to generate defects in the interconnection film; accordingly, harmful effects such as deteriorating the yield and operation performance of the FPDs are caused.

In this connection, in order to inhibit the sputtering defects from occurring, for instance, methods described in JP-A-10-147860, JP-A-10-199830, JP-A-11-293454 or JP-A-2001-279433 has been proposed. Among these, in JP-A-10-147860, JP-A-10-199830 and JP-A-11-293454 that are based on the viewpoint in that the splash is caused owing to fine voids in a target material texture, a dispersion state of particles of a compound of Al and a rare earth element in an Al matrix is controlled (JP-A-10-147860), a dispersion state of a compound of Al and a transition metal element in an Al matrix is controlled (JP-A-10-199830) or a dispersion state of an intermetallic compound between an additive element and A1 in a target is controlled (JP-A-11-293454) to inhibit the splash from occurring. Furthermore, JP-A-2001-279433 discloses a technology in which the hardness of a sputtering surface is controlled, followed by applying finish working to inhibit surface defects due to the mechanical working from occurring and thereby the arching generated at the sputtering is reduced.

Furthermore, JP-A-6-128737 discloses a method in which a ratio of crystallographic orientations in a sputtering surface of a sputtering target is controlled to enable to sputter at a high deposition rate. In JP-A-6-128737, it is described that when a content of a <111> crystallographic orientation when a sputtering surface is measured by X-ray diffractometry is made such high as 20% or more, a ratio of a target material flying in a direction vertical to a sputtering surface increases and thereby a thin film deposition rate is increased. In a column of examples, results when an Al-based alloy target containing 1% by weight of Si and 0.5% by weight of Cu is used are described.

Still furthermore, JP-A-6-81141, though not directly describing the deposition rate, discloses that in order to extend the electromigration life of an interconnection to improve the reliability of the interconnection, a content of a <200> crystallographic orientation when a sputtering surface is measured by X-ray diffractometry has only to be made such high as 20% or more. In a column of examples, results when an Al-based alloy target containing 1% by weight of Si and 0.5% by weight of Cu is used are described.

On the other hand, there has been disclosed a technology that inhibits a target from warping due to heating at the production of mainly a large target (see, JP-A-2006-225687). In JP-A-2006-225687, it is disclosed that, with an Al-Ni-rare earth element alloy sputtering target, when more than a predetermined number of compounds having an aspect ratio of 2.5 or more and a circle equivalent diameter of 0.2 $\mu$m or more are present in a cross section vertical to a target plane, the target can be sufficiently inhibited from deforming.

As mentioned above, although various technologies associated with overcoming the sputtering defects and improving deposition rate have been proposed, a further improvement has been demanded. In particular, in a Ni-containing Al-based alloy sputtering target that is used to form a thin film of an Al-Ni alloy or Al-Ni-rare earth element alloy useful as an interconnection material capable of directly being connected to an electroconductive oxide film that constitutes a pixel electrode, a technology that can overcome the problems has not yet been proposed.

The invention was carried out in view of the above-mentioned circumstances and intends to provide a technology that, when a Ni-containing Al-based alloy sputtering target is used, can improve the deposition rate and can suppress the sputtering defects such as the arching (irregular discharge) from occurring. In particular, the invention intends to provide a Ni-containing Al-based alloy sputtering target which does not cause a sputtering defect since a low sputter power condition can be used due to its high deposition rate even when high-rate deposition is applied, and a process for producing the same.

Fig. 1 is a diagram showing an arrangement and close packed directions of atoms of metal having a FCC crystal structure represented by Al.
Fig. 2 is a diagram showing an inverse pole figure map (crystallographic orientation map) when crystallographic orientations in a normal line direction of a sputtering surface of an Al-Ni-La alloy sputtering target are analyzed in accordance with the EBSP method.
Fig. 3 is a diagram showing an inverse pole figure map (crystallographic orientation map) when crystallographic orientations in a normal line direction of a sputtering surface of an Al-Nd alloy sputtering target are analyzed in accordance with the EBSP method.
Fig. 4 is a sectional view partially showing an example of a device used to produce a preform.
Fig. 5 is an enlarged diagram showing an essential part of X in Fig. 4.

Description of the Reference Numerals and Signs

1 induction melting furnace
2 Al-based alloy melt
3a and 3b gas atomizer
4a and 4b gas hole of bobbin
5 collector
6 nozzle
6a and 6b center axis of gas atomizing nozzle
A spray axis
L spray distance
$\alpha$ gas atomizer outlet angle
$\beta$ collector angle

Namely, the present invention relates to the following items 1 to 4.

1. An Al-based alloy sputtering target, comprising Ni in an amount of 0.05 to 10 atomic percent, wherein the Al-based alloy sputtering target satisfies:

(1) that a ratio of a P value to a total area of a sputtering surface is 70% or more, wherein the P value indicates a total of area fractions of <001> $\pm$ 15°, <011> $\pm$ 15°, <111> $\pm$ 15° and <311> $\pm$ 15°;
(2) that a ratio of the area fraction of <011> $\pm$ 15° to the P value is 30% or more; and
(3) that a ratio of the area fraction of <11> $\pm$ 15° to the P value is 10% or less, when crystallographic orientations <001>, <011>, <111> and <311> in a normal line direction to a sputtering surface of the Al-based alloy sputtering target are observed in accordance with the electron backscatter diffraction pattern method.

2. The Al-based alloy sputtering target according to item 1, which further comprises a rare earth element in an amount of 0.1 to 2 atomic percent.

3. A process for producing the Al-based alloy sputtering target according to item 1 or 2, comprising:

preparing a dense body of an Al-based alloy; then
forging the dense body of Al-based alloy to obtain a slab; then
rolling the slab under the conditions with a rolling temperature of 400 to 500°C, a rolling reduction per one pass of 5 to 15%, and a total rolling reduction of 60 to 90%; and then
conducting a heating at a temperature in a range of 300 to 400°C for 1 to 2 hours.

4. The process according to item 3, wherein said preparation of the dense body of an Al-based alloy includes:

producing an Al-based alloy preform in accordance with a spray forming method, and
densifying the Al-based alloy preform by means of a densifying means.

According to the Al-based alloy sputtering target of the invention, since crystallographic orientations in a normal line direction of a sputtering surface are adequately controlled, the deposition rate is heightened and the sputtering defects as well are effectively suppressed. Thus, according to the invention, since a high deposition rate can be obtained, the productivity can be very much improved and the sputtering defects remarkably occurring under high sputtering power condition can be further suppressed, without the necessity of increasing a sputtering power as before.

The inventors have made intensive studies to provide a technology that can suppress the sputtering defects such as the arching from occurring even when the deposition rate is heightened in a Ni-containing Al-based alloy sputtering target that is used to form a thin film of a Ni-containing Al-based alloy useful as an interconnection material capable of being directly connected (directly contactable) with an electroconductive oxide film that constitutes a pixel electrode. As the result, it is found that, when crystallographic orientations in a normal line direction of a sputtering surface of a Ni-containing Al-based alloy sputtering target are appropriately controlled, an expected purpose can be achieved, resulting in completing the invention.

In the specification, the "Al-based alloy" or "Ni-containing Al-based alloy" includes both an Al-Ni alloy containing Ni in an amount of 0.05 to 10 atomic percent and an Al-Ni-rare earth element alloy further containing a rare earth element such as Nd, La, Gd or Dy in an amount of 0.1 to 2 atomic percent.

In the specification, "the sputtering defects being suppressed" means that, in the case that the occurrence frequency of the arching is measured when a sputtering power corresponding to the deposition rate is set based on a method described in the examples as described below and the sputtering is carried out, the occurrence frequency of the arching is less than 80 (preferably less than 50).

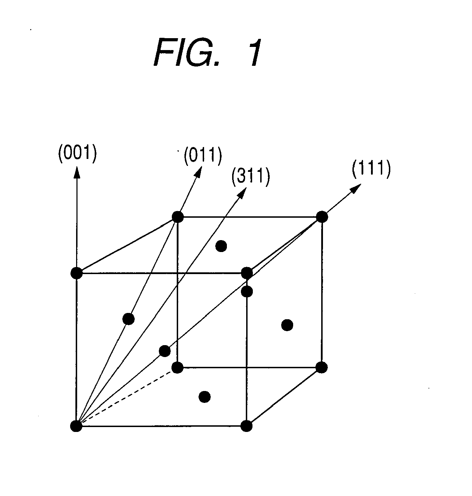

With reference to Fig. 1, crystallographic orientations that characterize an Al-based alloy of the invention will be described.

As shown in Fig. 1, Al has a crystal structure of a face-centered cubic lattice (FCC) and is known to mainly contain four kinds of crystallographic orientations of <011>, <001>, <111> and <311> as crystallographic orientations in a normal line direction of a sputtering surface of a sputtering target (a direction toward opposite substrates (ND)). An orientation where the atomic density is highest (close packed orientation) is <011>, followed by <001> and <111> in this order.

It is considered that, among Al-based alloys and pure Al, the Al-based alloys are particularly different in solid solution/precipitation modes depending on alloy systems thereby to generate a difference between behaviors of deformation and rotation of crystals, which results in difference in crystallographic orientation formation processes. As to JIS 5000 type Al-based alloys (Al-Mg system alloys) and JIS 6000 type Al-based alloys (Al-Mg-Si system alloys), tendency of the crystallographic orientation and instructions of a production process, which enables to control the crystallographic orientation, are clarified. However, as to the Al-based alloy that is used for FPD interconnection films, electrode films and reflective electrode films, the tendency of the crystallographic orientation and instructions of a production process, which enables to control the crystallographic orientation, have not been clarified.

In this connection, the inventors have studied to provide a crystallographic orientation control technology in a Ni-containing Al-based alloy in particular among Al-based alloys.

In order to make the deposition rate faster, it is said better to control the close-packed direction of atoms constituting a target generally made of a polycrystalline structure as far as possible so as to face a substrate on which a thin film is formed. In the course of sputtering, atoms constituting a target material are knocked out due to collisions with Ar ions. The mechanism thereof is said that (a) collided Ar ions intrude in between atoms of the target to rigorously vibrate surrounding target atoms, (b) the vibration is propagated in particular in a close-packed direction of atoms that are mutually in contact and transmitted to a surface and (c), as the result, atoms on a surface in a close-packed direction are knocked out. Accordingly, it is considered that, when the close-packed directions of individual atoms constituting the target face an opposite substrate, efficient sputtering can be realized and thereby a deposition rate is heightened.

The inventors have further studied from the above-mentioned viewpoints. As a result, it is found that, in a Ni-containing Al-based alloy sputtering target, an expected purpose can be achieved by making a ratio of <011> as high as possible and a ratio of <111> as low as possible, specifically, with setting a total area fractions of <001> $\pm$ 15°, <011> $\pm$ 15°, <111> $\pm$ 15° and <311> $\pm$ 15° as a P value, by controlling (1) a ratio of the P value to a total area of the sputtering surface to 70% or more, (2) a ratio of an area fraction of <011> $\pm$ 15° to the P value to 30% or more, and (3) an area fraction of <111> $\pm$ 15° to the P value to 10% less, thereby completing the invention.

With regard to a Si-containing Al-based alloy target, it is disclosed in JP-A-6-128737 and JP-A-6-81141 that, when a crystallographic orientation of <111> is heightened, the thin film deposition rate can be made faster (see JP-A-6-128737), and when a ratio of a crystallographic orientation of <200> (note: same as <001>) is heightened, the reliability of the interconnection can be heightened (see JP-A-6-81141). In the paragraph [0026] of JP-A-6-128737, it is described that it is considered because, in crystals having a <111> orientation surface normal line, due to the orientation thereof, at the sputtering, target materials having a velocity component in a direction vertical to a sputtering surface are much generated. This is utterly different from the instructions for controlling a crystallographic orientation according to the invention in which a ratio of <111> is made as low as possible.

Now, according to experiments of the inventors, it was clarified that, in the case of intending a Ni-containing Al-based alloy sputtering target as in the present invention, even when the crystallographic orientation control technologies disclosed in JP-A-6-128737 and JP-A-6-81141 (technologies where a ratio of <111> or <200> is heightened) were adopted, an expected advantage cannot be obtained.

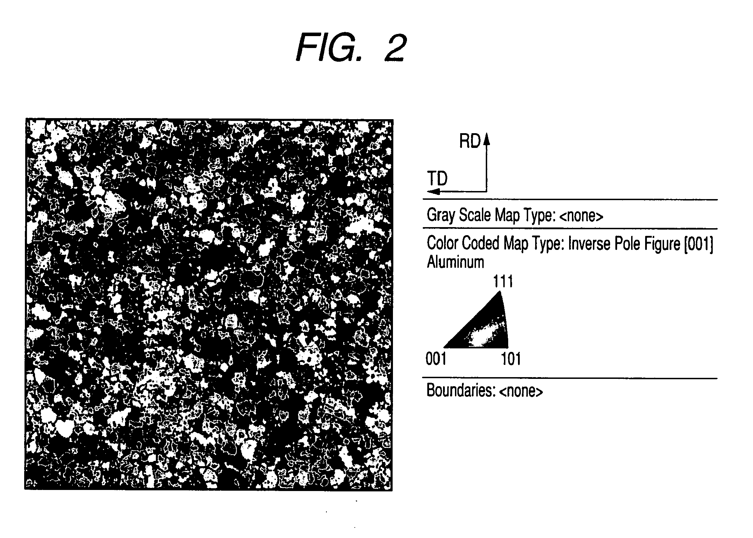

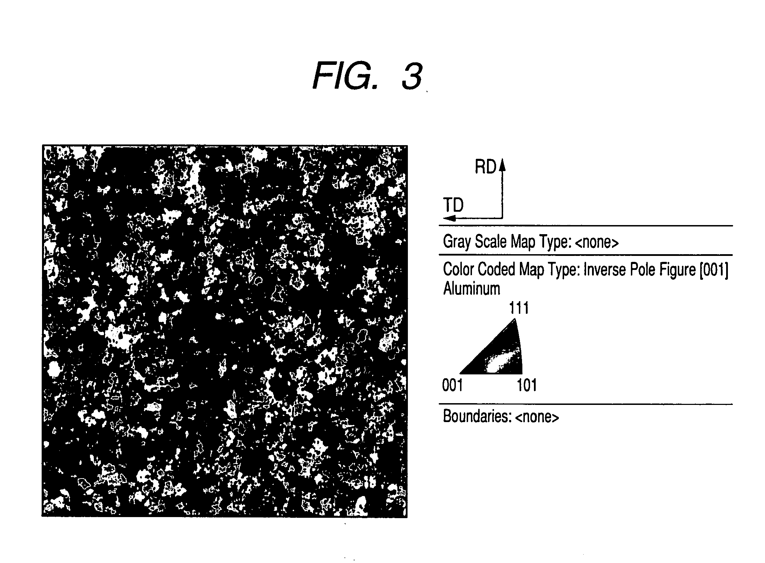

In particular, it was for the first time found by experiments of the inventors that, owing to the addition ofNi, crystallographic orientations of an Al-Ni-rare earth element alloy sputtering target and an Al-rare earth element alloy sputtering target are largely different from each other. In more detail, it was found that, although different strictly speaking in the kinds of rare earth elements, when, with each of a Ni-containing Al-Ni-rare earth element alloy (rare earth element = La) and an Al-rare earth element alloy that does not contain Ni but contains a rare earth element (rare earth element = Nd), a sputtering target was produced under the same conditions and crystallographic orientations were analyzed in accordance with the electron backscatter diffraction pattern (EBSP) method (this analysis method being described below), while an Al-Ni-La alloy sputtering target has a crystallographic orientation map where, as shown in Fig. 2, a ratio of <101> (note: a crystallographic orientation equivalent to <011>) expressed by green color becomes very abundant and a ratio of <111> expressed by blue color becomes very scarce; an Al-Nd alloy sputtering target that does not contain Ni has a crystallographic orientation map where, as shown in Fig. 3, a ratio of <101> (green color) is very scarce and a ratio of <311> (magenta color) is very abundant.

In the invention, crystallographic orientations of a Ni-containing Al based alloy are measured in accordance with the EBSP method. Before constituent elements of the invention are detailed, the EBSP method will be described.

In the EBSP method, an electron beam is impinged on a sample surface and a Kikuchi pattern obtained from reflected electrons generated at this time is analyzed to determine the crystallographic orientation of an incident position of the electron beam. When an electron beam is two-dimensionally scanned over a sample surface and the crystallographic orientation is measured at a predetermined pitch, an orientation distribution of a sample surface can be measured. According to the EBSP method, structures in a thickness direction, which are judged same according to an ordinary microscopic observation but different in the crystallographic orientation difference, can be advantageously differentiated with color differences.

For instance, Fig. 2 shows an inverse pole figure map (crystallographic orientation map) of the sample No. 4 (Al-2at%Ni-0.35at%La alloy) of Table 1 described in a column of examples described below. As shown in Fig. 2, each of the crystallographic orientations is identified with a color, <001> being expressed by red color, <101> (a crystallographic orientation equivalent with <011>) being expressed by green color, <111> being expressed by blue color and <311> being expressed by magenta color.

In the specification, the crystallographic orientations of a Ni-containing Al-based alloy sputtering targets are measured as follows.

In the beginning, a disc-shaped Ni-containing Al-based alloy sputtering target having a diameter of 101.6 mm and a thickness of 5.0 mm is prepared. The sputtering target is cut into a size of length 10 mm $\times$ width 10 mm $\times$ thickness 15 mm to prepare an EBSP measurement sample. By the use of a device and software mentioned below, the crystallographic orientations of the sputtering target are measured.

Device: Electron Backscatter Diffraction Pattern Analyzer "Orientation Imaging Microscopy™ (OIM™)" (trade name, produced by EDAX/TSL Corp.)

Measurement Software: OIM Data Collection ver. 4

Analysis Software: OIM Analysis ver. 4

Measurement Region: area 100 $\mu$m $\times$ 100 $\mu$m $\times$ depth 50 nm

Crystallographic orientation difference at the analysis: $\pm$ 15°

Herein, "the crystallographic orientation difference at the analysis: $\pm$ 15°" means that when for instance a <001> crystallographic orientation is analyzed, a range within <001> ± 15° is ascribed as a tolerable range and judged as a <001> crystallographic orientation. This is because the above-mentioned tolerable range can be considered ascribable as crystallographically same orientation. As shown below, in the present invention, all of the respective crystallographic orientations are calculated within a tolerable range of ± 15°. A partition fraction of a crystallographic orientation <uvw> ± 15° was obtained as an area fraction.

In what follows, constituent requirements (1) through (3) of the invention will be described.

(1) With setting a total of area fractions of <001> ± 15°, <011> ± 15°, <111> ± 15° and <311> ± 15° as a P value, a ratio of the P value to a total area of a sputtering surface being 70% or more

In the beginning, in the invention, as mentioned above, four targeted crystallographic orientations <001>, <011>, <111> and <311> are measured at the tolerable crystallographic orientation difference of ± 15° and a total of the area fractions in these crystallographic orientations (P value) is calculated. In the invention, in particular, the four orientations that are main crystallographic orientations present in an orientation direction of a sputtering target surface normal line are targeted and a total of the area fractions in these crystallographic orientations (P value) is set to 70% or more. This is because, when the P value is less than 70%, defects such as grain boundaries are detected a lot (substantially 30% or more) to deteriorate the quality.

In the invention, with a premise that the P value satisfies the requirement (1), ratios of the respective crystallographic orientations of <011> and <111> to the P value are required to satisfy the requirements of formulas (2) and (3) below.

(2) {area fraction of <011> ± 15°} × 100/P value ≥ 30%

In the invention, as shown in the formula (2), a ratio of <011> that is a close packed orientation of a Ni-containing Al-based alloy is made largest. As will be shown in examples shown below, when a ratio of <011> is less than 30%, a desired deposition rate cannot be obtained and the sputtering defects cannot be effectively suppressed. The larger the ratio of <011> is the better. For instance, it is preferably 40% or more and more preferably 50% or more. The upper limit thereof is not particularly set and it can include 100%. However, from the practical operation point of view, the maximum controllable ratio is substantially about 60%.

(3) {area fraction of <111> ± 15°} × 100/P value ≤ 10%

Furthermore, in the invention, as shown in the formula (3), a ratio of <111> that is the sparsest orientation of the Ni-containing Al-based alloy is made smallest. As shown in examples shown below, when the ratio of <111> exceeds 10%, a desired deposition rate cannot be obtained and the sputtering defects cannot be effectively suppressed. The smaller the ratio of <111> is the better. For instance, it is preferably 8% or less and more preferably 5% or less. The lower limit thereof is not particularly set and it can include 0%. However, from the practical operation point of view, the minimum controllable ratio is substantially about 1%.

Inclusion ratios of crystallographic orientations (<001> and <311>) that are measuring objects other than the above are not particularly restricted. It is experimentally confirmed that, in order to improve the deposition rate and reduce the sputtering defects, the crystallographic orientations of <011> and <111> have only to be stipulated as the formulas (2) and (3) show and influence of the other crystallographic orientations (<001> and <311>) is hardly necessary to consider.

The crystallographic orientations that characterize the invention have been described above.

In the next place, an Al-based alloy sputtering target that is an object of the invention will be described.

As mentioned above, in the invention, a Ni-containing Al-based alloy sputtering target (Al-Ni-alloy sputtering target and Al-Ni-rare earth element sputtering target) is an object to be considered. This is because, as mentioned in JP-A-2004-214606, a thin film of an Al-Ni alloy, being able to directly connect with a pixel electrode, and a rare earth element-containing Al-Ni-rare earth element alloy, being capable of further improving the heat resistance as well, are very useful as a direct contactable wiring material.

In the invention, the content of Ni is set in an amount of 0.05 to 10 atomic percent, which is expanded larger than the upper limit (6 atomic percent) of Ni content described in JP-A-2004-214606. This is based on the experimental confirmation in that the crystallographic orientation control technology of the invention can be applied over to an Al-Ni alloy sputtering target in which the upper limit of Ni is 10 atomic percent at the maximum. This is because, as shown in examples below, when the content of Ni is less than 0.05 atomic percent, the respective crystallographic orientations of <011> and <111> cannot be controlled within the ranges of the formulas (2) and (3), and, when the content of Ni exceeds 10 atomic percent, since grains are finely pulverized to exhibit random crystallographic orientations, the respective crystallographic orientations of <011> and <111> cannot be controlled within the ranges of (2) and (3). From the standpoint of "easiness to control the crystallographic orientation", the content of Ni is preferably 0.1 atomic percent to 6 atomic percent, more preferably 0.2 atomic percent to 4 atomic percent.

Furthermore, in the invention, an Al-Ni-rare earth element alloy sputtering target that further contains a rare earth element such as Nd and La is as well an object to be considered. In the specification, "rare earth elements" mean Y, lanthanoid elements and actinoid elements in the periodic table. An Al-Ni-alloy sputtering target containing La or Nd can be preferably used. The rare earth elements may be used singularly or in a combination of at least two kinds thereof.

The content of the rare earth element (total amount when at least two kinds thereof are contained) is preferably 0.1 atomic percent to 2 atomic percent, more preferably 0.15 atomic percent to 1 atomic percent.

In the next place, a production process of an Al-based alloy sputtering target of the invention will be described.

A production process of the invention includes: a first step of preparing a dense body of an Al-based alloy; a second step of forging the dense body of Al-based alloy to obtain a slab; a third step of rolling the slab under the conditions with a rolling temperature of 400 to 500°C, a rolling reduction per one pass of 5 to 15% and a total rolling reduction of 60 to 90%; and a fourth step of conducting a heating at a temperature in the range of 300 to 400°C for 1 to 2 hours. Accordingly, a sputtering target of which crystallographic orientations are controlled as mentioned above can be obtained.

In what follows, the respective steps will be described.

(First step)

Firstly, a dense body of Al-based alloy is prepared. A composition of the Al-based alloy is as mentioned above, that is, an Al-Ni alloy containing Ni in an amount of 0.05 to 10 atomic percent or an Al-Ni-rare earth element alloy further containing a rare earth element in an amount of 0.1 to 2 atomic percent.

Specifically, in the beginning, after an Al-based alloy preform (an intermediate body before obtaining a final dense body) is formed by the use of a spray forming method, the preform is preferably densified by the use of densifying means.

Herein, the spray forming method is a method where various kinds of molten metals are atomized with a gas and particles quenched in a semi-molten state/semi-soldification state/solid state are deposited to obtain a preform having a predetermined shape. According to the method, there are various advantages that, in addition that a large preform that is difficult to obtain according to a melt casting method or a powder metallurgy method can be obtained in a single process, grains can be made fine and alloy elements can be uniformly dispersed.

A detailed method of the spray forming method is not particularly restricted. Technologies disclosed in, for instance, IP-A-9-248665, JP-A-11-315373 and JP-A2000-82855 can be adopted. Furthermore, a method described in JP-A-2006-73337 can be adopted as well.

Specifically, a preform is preferably produced according to a method described in JP-A-2006-73337.

The step of producing a preform preferably includes: melting an Al-based alloy at a temperature in the range of (liquidus temperature + 100°C) to (liquidus temperature + 400°C) to obtain a melt of an Al-based alloy; gas atomizing the melt of the Al-based alloy under the conditions with a gas/metal ratio expressed by a ratio of gas outflow/melt outflow of 4 Nm$^3$/kg or more and $\alpha$ in the range of 1 to 10° in which an angle formed between center axes of opposite gas atomizing nozzles is expressed with $2\alpha$, in order for miniaturization; and depositing the miniaturized Al-based alloy on a collector under the conditions with a spray distance of 700 to 1200 mm and a collector angle of 20 to 45° to obtain a preform.

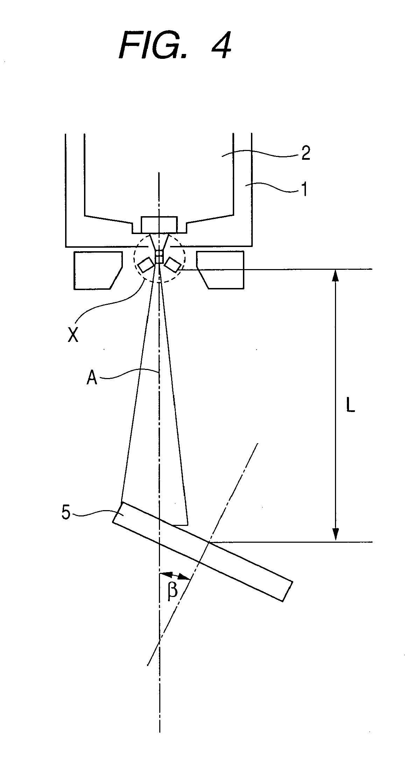

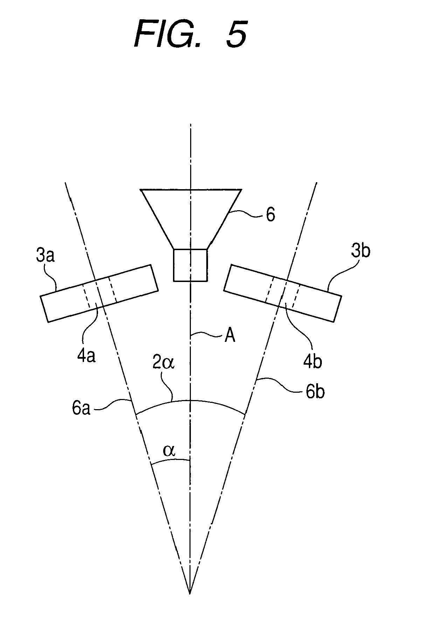

In what follows, with reference to Figs. 4 and 5, the respective steps for obtaining a preform will be detailed.

Fig. 4 is a sectional view partially showing an example of a device used to produce a preform of the invention. Fig. 5 is an enlarged view of as essential part of X in Fig. 4.

A device shown in Fig. 4 includes an induction melting furnace 1 for melting an Al-based alloy; gas atomizers 3a and 3b disposed below the induction melting furnace 1; and a collector 5 for depositing a preform. The induction melting furnace 1 includes a nozzle 6 for dropping a melt 2 of the Al-based alloy. Furthermore, the gas atomizers 3a and 3b, respectively, have gas holes 4a and 4b of bobbins for atomizing a gas. The collector 5 includes driving means (not shown in the drawing) such as a stepping motor.

In the beginning, an Al-based alloy having above-mentioned composition is prepared. The Al-based alloy is put in the induction melt furnace 1, followed by, preferably in an inert gas (for instance, Ar gas) atmosphere, melting at a temperature in the range of +100°C to +400°C to a liquidus temperature of the Al-based alloy to obtain a melt 2 of the Al-based alloy.

In the next place, the alloy melt 2 obtained as mentioned above is dropped in a chamber (not shown in the drawing) having an inert atmosphere through a nozzle 6. In the chamber, from gas holes 4a and 4b of bobbins provided to the gas atomizers 3a and 3b, a jet flow of pressurized inert gas is sprayed to the melt 2 of the alloy thereby to miniaturize the alloy melt.

The gas atomization is preferably carried out, as mentioned above, with an inert gas or a nitrogen gas, whereby the melt can be inhibited from oxidizing. As the inert gas, for instance, an argon gas can be cited.

Herein, a gas/metal ratio is preferably set at 4 Nm$^3$/kg or more. The gas/metal ratio is expressed by a ratio of gas outflow/melt outflow. In the specification, the gas outflow means a sum total (finally used amount) of a gas flowed out of the gas holes 4a and 4b of the bobbins for gas atomizing the melt of the Al-based alloy. Furthermore, in the specification, the melt outflow means a sum total of a melt outflowed from a melt outflow port (nozzle 6) of a vessel (induction melt furnace 1) in which the melt of the Al-based alloy is present.

Furthermore, when an angle that center axes 6a and 6b of the opposing gas atomizing nozzles form is expressed by 2α, α is preferably controlled in the range of 1 to 10°. An angle 2α that center axes 6a and 6b of the opposing gas atomizing nozzles form means a total angle of the respective inclinations α of the gas atomizers 4a and 4b relative to a line (corresponding to a spray axis A) when the melt 2 vertically drops. In what follows, the α is called as a "gas atomizer outlet angle α".

Subsequently, thus miniaturized Al-based alloy (liquid drops) is deposited on the collector 5 to obtain a preform.

Herein, a spray distance is preferably controlled in the range of 700 to 1200 mm. The spray distance defines a deposition position of a liquid drop and, as shown in Fig. 4, it means a distance L from a tip end of the nozzle 6 to a center of the collector 5. As will be described below, since the collector 5 tilts at a collector angle β, the spray distance L means, strictly speaking, a distance between the tip end of the nozzle 6 and a point Al where the center of the collector 5 comes into contact with a spray axis A. Herein, the spray axis A defines, for the sake of convenience of description, a direction along which a liquid drop of the Al-based alloy falls straight.

Furthermore, the collector angle β is preferably controlled in the range of 20 to 45°. The collector angle β means, as shown in Fig. 4, an inclination of the collector 5 to the spray axis A.

The dense body obtained from the preform has a fine structure and can remarkably inhibit the splash from occurring.

In the above, a preferable method for obtaining the preform was described.

In the next place, the densifying means are applied to the preform to obtain an Al-based alloy dense body. As the densifying means, a method of substantially uniformly pressurizing a preform, in particular, a hot isostatic pressing (HIP) where pressure is applied under heating, is preferably applied. Specifically, the HIP treatment is applied preferably, for instance, under pressure of 80 MPa or more at a temperature in the range of 400 to 600°C. The time period of the HIP treatment is preferably in the range of substantially 1 to 10 hours.

(Second Step)

Then, the Al-based alloy dense body is forged to form a slab (substantially thickness: 60 mm, width: 540 mm).

The forging condition is not particularly restricted so long as a method that is usually used to produce a sputtering target is used. However, the forging is preferably applied under the conditions with, for instance, a heating temperature of the Al-based alloy dense body before forging of substantially 500°C, the heating time of 1 to 3 hours and the upsetting ratio per one forging of 10% or less.

(Third Step)

To the slab obtained as mentioned above, a rolling process is applied under the conditions with a rolling temperature of 400 to 500°C, the rolling reduction per one pass of 5 to 15% and a total rolling reduction of 60 to 90%. The rolling temperature is generally in the range of 300 to 550°C. However, in the invention, the rolling temperature is controlled in the range of 400 to 500°C. Furthermore, although the rolling reduction per one pass is generally set at several percent, in the invention, it is controlled in the range of 5 to 15% a little higher than the above. Still further more, although the total rolling reduction is generally in the range of 40 to 90%, in the invention, it is controlled in the range of 60 to 90% a little bit higher than that. As will be shown in examples described below, in the invention, the rolling conditions are required to be controlled delicately as mentioned above. When the rolling is applied under conditions in which any one of the conditions is outside the above-mentioned range, desired crystallographic orientations cannot be obtained.

The rolling is substantially carried out preferably under the conditions with the rolling temperature of 420°C to 480°C, the rolling reduction per one pass of 7% to 13%, and the total rolling reduction of 65% to 85%; and more preferably under the conditions with the rolling temperature of 440°C to 460°C, the rolling reduction per one pass of 9% to 11%, and the total rolling reduction of 70% to 80%.

Herein, the rolling reduction per one pass and the total rolling reduction, respectively, are expressed by the following formulas.

$$\text{Rolling reduction per one pass (\%)} = \{(\text{thickness before rolling one pass}) -$$

$$(\text{thickness after rolling one pass})\}/(\text{thickness before rolling one pass}) \times 100$$

$$\text{Total rolling reduction (\%)} = \{(\text{thickness before rolling}) - (\text{thickness after rolling})\}/(\text{thickness before rolling}) \times 100$$

The Al-based alloy produced by the spray forming method, being difficult to cause a change in a structure during the processing, can be produced according to either one of the cold rolling and hot rolling. However, in order to heighten the processing rate per one pass, an Al-based alloy material can be effectively heated and processed in a temperature range low in the deformation resistance; accordingly, the hot rolling is preferably adopted.

(Fourth Step)

In the next place, a heating process (heat treatment or annealing) is applied at a temperature in the range of 300 to 400°C for 1 to 2 hours. In the invention, as will be shown in examples described below, together with the rolling conditions, heating conditions after the rolling are required to be delicately controlled as mentioned above. When any one of the conditions, which is outside the above-mentioned range, is used for the heat treatment, desired crystallographic orientations cannot be obtained.

The heating temperature is substantially preferred to be 320°C or more and 380°C or less and more preferred to be 340°C or more and 360°C or less. The heating time is substantially preferred to be 1.2 hours to 1.8 hours and more preferred to be 1.4 hours to 1.6 hours.

An atmosphere during the heating process is not particularly restricted, and may be any one of air, inert gas and vacuum. However, in view of the productivity and cost, heating in air is preferred.

When a machining process is applied into a predetermined shape after the heat treatment, a sputtering target can be obtained.

Examples

Hereinafter, with reference to examples, the invention will be more specifically described. However, the invention is not restricted to or by the examples below, and can be carried out by appropriately modifying within a range that can adapt to the gist of the invention and all these are contained in the technical range of the invention.

Example 1

With Al-based alloys of which compositions are shown in tables 1 and 2, according to the following spray forming method, Al-based alloy preforms (density: substantially 50 to 60%) were obtained.

(Spray forming conditions)
Melt temperature: 1000°C
Gas/metal ratio: 6 $Nm^3$/kg
Spray distance: 1050 mm
Gas atomizer outlet angle: 7°
Collector angle: 35°

Subsequently, each of the obtained preforms was sealed in a capsule, followed by deaerating, and then densified with a HIP device. The HIP process was carried out at a HIP temperature of 550°C under a HIP pressure of 85 MPa for the HIP time of 2 hours.

Thus obtained Al-based alloy dense body was forged under the conditions with a heating temperature before forging of 500°C, a heating time of 2 hours and the upsetting ratio per one time of 10% or less, whereby a slab was obtained (size: thickness 60 mm, width 540 mm and length 540 mm).

Then, under various conditions shown in Tables 1 and 2, the rolling (heating time before rolling: 2 hours) and heat treatment were applied, followed by applying the machine processing to produce an Al-based alloy sheet (thickness: 8 mm, width: 150 mm and length: 150 mm).

In the next place, the Al-based alloy sheet was subjected to corner cutting work and turning work, whereby a disc-shaped sputtering target (diameter: 101.6 mm × thickness 5.0 mm) was obtained.

Using the sputtering targets, crystallographic orientations in a normal line direction of a sputtering surface were measured and analyzed in accordance with the EBPS method.

Furthermore, using the sputtering targets, the deposition rate and the occurrence frequency of the sputtering defects during the thin film formation were measured as follows.

(Measurement of the deposition rate)

Sputtering device: HSM-552 (trade name, produced by Shimadzu Corp.)
Sputtering conditions:

Backpressure: $0.27 \times 10^{-3}$ Pa or less, Ar gas pressure: 0.27 Pa, Ar gas flow rate: 30 sccm, sputtering power: DC260W, polar distance: 52 mm, substrate temperature: room temperature, sputtering time: 120 sec

Measurement method:

On a glass substrate (trade name: #1737, produced by Coming Corp., diameter: 50.8 mm, thickness: 0.7 mm), a sputtering operation was carried out under the above-mentioned conditions to prepare a thin film. A thickness of the obtained thin film was measured with a stylus type film thickness meter (trade name: alpha-step 250, produced by TENCOR INSTRUMENTS CO.).

The deposition rate was calculated based on the following formula.

$$\text{Deposition rate (nm/s)} = \text{thickness of thin film (nm)/sputtering time (s)}$$

(Measurement of occurrence frequency of sputtering defects)

In the examples, the occurrence frequencies of the arching that is likely to occur under the high sputtering power condition were measured to evaluate the occurrence of the sputtering defects.

In the beginning, for Al-0.35at%La alloy (Ni = 0 atomic percent) sputtering targets, as shown in Table 1, a thin film was deposited at the deposition rate of 2.65 nm/s. Herein, a product of the deposition rate and the sputtering power DC, a Q value, is as follows.

$$\text{Q value} = \text{deposition rate (2.65 nm/s)} \times \text{sputtering power DC (260W)} = 689$$

In the next place, for Al-Ni-0.35at%La alloy sputtering targets containing various amounts ofNi as shown in Table 1, based on the Q value (constant), the sputtering powers DC corresponding to the deposition rates shown in Table 1 were set to apply the sputtering.

For instance, sputtering conditions of an Al-0.01at%Ni-0.35at%La alloy sputtering target are as follows.

Deposition rate: 2.77 nm/s

Based on the following formula, the sputtering power DC was set at 249W:

$$\text{Sputtering power DC} = \text{Q value (689)/deposition rate (2.77)} \approx 249W$$

Sputtering time: 1 hour

The presence of absence of the occurrence of sputtering defects was measured by the use of an arch monitor (trade name: Micro Arch Monitor "MAM Genesis", produced by Landmark Technology Co., Ltd.). According to the method, whether the arching occurred or not can be quantitatively measured. In the invention, according to the following criteria, the occurrence of the sputtering defects was evaluated.

No occurrence of sputtering defect: the occurrence frequency of arching is less than 80

Occurrence of sputtering defect: the occurrence frequency is 80 or more

The results are shown together in Tables 1 and 2. In the respective tables, "judgment" column is provided, and one in which the sputtering defect was not found is expressed by A (acceptable) and one in which the sputtering defect was found is expressed by B (unacceptable). Still furthermore, in Tables 1 and 2, the results of the sample No. 4 are shown a plurality of times. These are described for the convenience of description and intend to more clarify influence of the every process (for instance, in the table, column A for the rolling temperature and column B for the rolling reduction per one pass).

EP 1 932 940 A1

Table 1

| Column | No. | Composition | | Rolling conditions | | | Heat treatment conditions | | Crystallographic orientation in a normal line direction of sputtering surface | | | Deposition rate (nm/s) | Occurrence of sputtering defects | Judgment |
|---|---|---|---|---|---|---|---|---|---|---|---|---|---|---|
| | | Alloy | Ni content (atomic percent) | Temperature (°C) | Rolling reduction per one pass (%) | Total rolling reduction (%) | Temperature (°C) | Time (h) | Total area fractions of crystallographic orientations, P value | Area fraction of <011> ± 15° (%) | Area fraction of <111> ± 15° (%) | | | |
| A | 1 | Al-Ni-0.35at%La | 0 | 450 | 10 | 75 | 350 | 1.5 | 75 | 20 | 20 | 2.65 | Yes | B |
| | 2 | Al-Ni-0.35at%La | 0.01 | 450 | 10 | 75 | 350 | 1.5 | 77 | 25 | 15 | 2.77 | Yes | B |
| | 3 | Al-Ni-0.35at%La | 0.05 | 450 | 10 | 75 | 350 | 1.5 | 79 | 30 | 10 | 2.89 | No | A |
| | 4 | Al-Ni-0.35at%La | 2 | 450 | 10 | 75 | 350 | 1.5 | 80 | 41 | 7 | 3.05 | No | A |
| | 5 | Al-Ni-0.35at%La | 10 | 450 | 10 | 75 | 350 | 1.5 | 78 | 33 | 8 | 2.94 | No | A |
| | 6 | Al-Ni-0.35at%La | 12 | 450 | 10 | 75 | 350 | 1.5 | 76 | 25 | 13 | 2.79 | Yes | B |
| B | 7 | Al-Ni-0.35at%La | 2 | 350 | 10 | 75 | 350 | 1.5 | 76 | 28 | 17 | 2.76 | Yes | B |
| | 8 | Al-Ni-0.35at%La | 2 | 400 | 10 | 75 | 350 | 1.5 | 79 | 30 | 10 | 2.89 | No | A |
| | 4 | Al-Ni-0.35at%La | 2 | 450 | 10 | 75 | 350 | 1.5 | 80 | 41 | 7 | 3.05 | No | A |
| | 9 | Al-Ni-0.35at%La | 2 | 500 | 10 | 75 | 350 | 1.5 | 80 | 34 | 9 | 2.94 | No | A |
| | 10 | Al-Ni-0.35at%La | 2 | 550 | 10 | 75 | 350 | 1.5 | 77 | 23 | 15 | 2.74 | Yes | B |

Table 1 (Continued)

| Column | No. | Composition | | Rolling conditions | | | Heat treatment conditions | | Crystallographic orientation in a normal line direction of sputtering surface | | | Deposition rate (nm/s) | Occurrence of sputtering defects | Judgment |
|---|---|---|---|---|---|---|---|---|---|---|---|---|---|---|
| | | Alloy | Ni content (atomic percent) | Temperature (°C) | Rolling reduction per one pass (%) | Total rolling reduction (%) | Temperature (°C) | Time (h) | Total area fractions of crystallographic orientations, P value | Area fraction of <011> ± 15° (%) | Area fraction of <111> ± 15° (%) | | | |
| C | 11 | Al-Ni-0.35at%La | 2 | 450 | 2 | 75 | 350 | 1.5 | 76 | 22 | 18 | 2.70 | Yes | B |
| | 12 | Al-Ni-0.35at%La | 2 | 450 | 5 | 75 | 350 | 1.5 | 79 | 30 | 10 | 2.89 | No | A |
| | 4 | Al-Ni-0.35at%La | 2 | 450 | 10 | 75 | 350 | 1.5 | 80 | 41 | 7 | 3.05 | No | A |
| | 13 | Al-Ni-0.35at%La | 2 | 450 | 15 | 75 | 350 | 1.5 | 80 | 33 | 8 | 2.94 | No | A |
| | 14 | Al-Ni-0.35at%La | 2 | 450 | 20 | 75 | 350 | 1.5 | 78 | 21 | 12 | 2.76 | Yes | B |
| D | 15 | Al-Ni-0.35at%La | 2 | 450 | 10 | 50 | 350 | 1.5 | 75 | 24 | 16 | 2.74 | Yes | B |
| | 16 | Al-Ni-0.35at%La | 2 | 450 | 10 | 60 | 350 | 1.5 | 78 | 30 | 10 | 2.89 | No | A |
| | 4 | Al-Ni-0.35at%La | 2 | 450 | 10 | 75 | 350 | 1.5 | 80 | 41 | 7 | 3.05 | No | A |
| | 17 | Al-Ni-0.35at%La | 2 | 450 | 10 | 90 | 350 | 1.5 | 79 | 32 | 8 | 2.93 | No | A |
| | 18 | Al-Ni-0.35at%La | 2 | 450 | 10 | 95 | 350 | 1.5 | 78 | 22 | 14 | 2.74 | Yes | B |

Table 1 (Continued)

| Column | No. | Composition | | Rolling conditions | | | Heat treatment conditions | | Crystallographic orientation in a normal line direction of sputtering surface | | | Deposition rate (nm/s) | Occurrence of sputtering defects | Judgment |
|---|---|---|---|---|---|---|---|---|---|---|---|---|---|---|
| | | Alloy | Ni content (atomic percent) | Temperature (°C) | Rolling reduction per one pass (%) | Total rolling reduction (%) | Temperature (°C) | Time (h) | Total area fractions of crystallographic orientations, P value | Area fraction of <011> ± 15° (%) | Area fraction of <111> ± 15° (%) | | | |
| E | 19 | Al-Ni-0.35at%La | 2 | 450 | 10 | 75 | 250 | 1.5 | 76 | 21 | 18 | 2.69 | Yes | B |
| | 20 | Al-Ni-0.35at%La | 2 | 450 | 10 | 75 | 300 | 1.5 | 79 | 30 | 10 | 2.89 | No | A |
| | 4 | Al-Ni-0.35at%La | 2 | 450 | 10 | 75 | 350 | 1.5 | 80 | 41 | 7 | 3.05 | No | A |
| | 21 | Al-Ni-0.35at%La | 2 | 450 | 10 | 75 | 400 | 1.5 | 79 | 34 | 9 | 2.94 | No | A |
| | 22 | Al-Ni-0.35at%La | 2 | 450 | 10 | 75 | 450 | 1.5 | 78 | 20 | 11 | 2.76 | Yes | B |
| F | 23 | Al-Ni-0.35at%La | 2 | 450 | 10 | 75 | 350 | 0.3 | 77 | 25 | 19 | 2.72 | Yes | B |
| | 24 | Al-Ni-0.35at%La | 2 | 450 | 10 | 75 | 350 | 1 | 78 | 30 | 10 | 2.89 | No | A |
| | 4 | Al-Ni-0.35at%La | 2 | 450 | 10 | 75 | 350 | 1.5 | 80 | 41 | 7 | 3.05 | No | A |
| | 25 | Al-Ni-0.35at%La | 2 | 450 | 10 | 75 | 350 | 2 | 81 | 33 | 8 | 2.94 | No | A |
| | 26 | Al-Ni-0.35at%La | 2 | 450 | 10 | 75 | 350 | 3 | 80 | 24 | 13 | 2.78 | Yes | B |

EP 1 932 940 A1

13

EP 1 932 940 A1

## Table 2

| Column | No. | Composition | | Rolling conditions | | | Heat treatment conditions | | Crystallographic orientation in a normal line direction of sputtering surface | | | Deposition rate (nm/s) | Occurrence of sputtering defects | Judgment |
|---|---|---|---|---|---|---|---|---|---|---|---|---|---|---|
| | | Alloy | Ni content (atomic percent) | Temperature (°C) | Rolling reduction per one pass (%) | Total rolling reduction (%) | Temperature (°C) | Time (h) | Total area fractions of crystallographic orientations, P value | Area fraction of <011> ± 15° (%) | Area fraction of <111> ± 15° (%) | | | |
| A | 1 | Al-Ni-0.6at%Nd | 0 | 450 | 10 | 75 | 350 | 1.5 | 74 | 19 | 22 | 2.70 | Yes | B |
| | 2 | Al-Ni-0.6at%Nd | 0.01 | 450 | 10 | 75 | 350 | 1.5 | 77 | 24 | 17 | 2.82 | Yes | B |
| | 3 | Al-Ni-0.6at%Nd | 0.05 | 450 | 10 | 75 | 350 | 1.5 | 79 | 30 | 10 | 2.98 | No | A |
| | 4 | Al-Ni-0.6at%Nd | 2 | 450 | 10 | 75 | 350 | 1.5 | 80 | 39 | 8 | 3.11 | No | A |
| | 5 | Al-Ni-0.6at%Nd | 10 | 450 | 10 | 75 | 350 | 1.5 | 78 | 32 | 9 | 3.01 | No | A |
| | 6 | Al-Ni-0.6at%Nd | 12 | 450 | 10 | 75 | 350 | 1.5 | 78 | 23 | 12 | 2.87 | Yes | B |
| B | 7 | Al-Ni-0.6at%Nd | 12 | 350 | 10 | 75 | 350 | 1.5 | 75 | 28 | 19 | 2.80 | Yes | B |
| | 8 | Al-Ni-0.6at%Nd | 12 | 400 | 10 | 75 | 350 | 1.5 | 79 | 30 | 10 | 2.98 | No | A |
| | 4 | Al-Ni-0.6at%Nd | 12 | 450 | 10 | 75 | 350 | 1.5 | 80 | 39 | 8 | 3.11 | No | A |
| | 9 | Al-Ni-0.6at%Nd | 12 | 500 | 10 | 75 | 350 | 1.5 | 81 | 33 | 9 | 3.03 | No | A |
| | 10 | Al-Ni-0.6at%Nd | 12 | 550 | 10 | 75 | 350 | 1.5 | 80 | 21 | 17 | 2.78 | Yes | B |

14

Table 2 (Continued)

| Column | No. | Composition | | Rolling conditions | | | Heat treatment conditions | | Crystallographic orientation in a normal line direction of sputtering surface | | | Deposition rate (nm/s) | Occurrence of sputtering defects | Judgment |
|---|---|---|---|---|---|---|---|---|---|---|---|---|---|---|
| | | Alloy | Ni content (atomic percent) | Temperature (°C) | Rolling reduction per one pass (%) | Total rolling reduction (%) | Temperature (°C) | Time (h) | Total area fractions of crystallographic orientations, P value | Area fraction of <011> ± 15° (%) | Area fraction of <111> ± 15° (%) | | | |
| C | 11 | Al-Ni-0.6at%Nd | 12 | 450 | 2 | 75 | 350 | 1.5 | 76 | 20 | 21 | 2.72 | Yes | B |
| | 12 | Al-Ni-0.6at%Nd | 12 | 450 | 5 | 75 | 350 | 1.5 | 78 | 30 | 10 | 2.98 | No | A |
| | 4 | Al-Ni-0.6at%Nd | 12 | 450 | 10 | 75 | 350 | 1.5 | 80 | 39 | 8 | 3.11 | No | A |
| | 13 | Al-Ni-0.6at%Nd | 12 | 450 | 15 | 75 | 350 | 1.5 | 77 | 33 | 9 | 3.03 | No | A |
| | 14 | Al-Ni-0.6at%Nd | 12 | 450 | 20 | 75 | 350 | 1.5 | 77 | 19 | 15 | 2.78 | Yes | B |
| D | 15 | Al-Ni-0.6at%Nd | 12 | 450 | 10 | 50 | 350 | 1.5 | 76 | 21 | 19 | 2.76 | Yes | B |
| | 16 | Al-Ni-0.6at%Nd | 12 | 450 | 10 | 60 | 350 | 1.5 | 80 | 30 | 10 | 2.98 | No | A |
| | 4 | Al-Ni-0.6at%Nd | 12 | 450 | 10 | 75 | 350 | 1.5 | 80 | 39 | 8 | 3.11 | No | A |
| | 17 | Al-Ni-0.6at%Nd | 12 | 450 | 10 | 90 | 350 | 1.5 | 82 | 32 | 8 | 3.03 | No | A |
| | 18 | Al-Ni-0.6at%Nd | 12 | 450 | 10 | 95 | 350 | 1.5 | 79 | 21 | 16 | 2.78 | Yes | B |

EP 1 932 940 A1

Table 2 (Continued)

| Column | No. | Composition | | Rolling conditions | | | Heat treatment conditions | | Crystallographic orientation in a normal line direction of sputtering surface | | | Deposition rate (nm/s) | Occurrence of sputtering defects | Judgment |
|---|---|---|---|---|---|---|---|---|---|---|---|---|---|---|
| | | Alloy | Ni content (atomic percent) | Temperature (°C) | Rolling reduction per one pass (%) | Total rolling reduction (%) | Temperature (°C) | Time (h) | Total area fractions of crystallographic orientations, P value | Area fraction of <011> ± 15° (%) | Area fraction of <111> ± 15° (%) | | | |
| E | 19 | Al-Ni-0.6at%Nd | 12 | 450 | 10 | 75 | 250 | 1.5 | 75 | 19 | 19 | 2.74 | Yes | B |
| | 20 | Al-Ni-0.6at%Nd | 12 | 450 | 10 | 75 | 300 | 1.5 | 78 | 30 | 10 | 2.98 | No | A |
| | 4 | Al-Ni-0.6at%Nd | 12 | 450 | 10 | 75 | 350 | 1.5 | 80 | 39 | 8 | 3.11 | No | A |
| | 21 | Al-Ni-0.6at%Nd | 12 | 450 | 10 | 75 | 400 | 1.5 | 80 | 33 | 8 | 3.04 | No | A |
| | 22 | Al-Ni-0.6at%Nd | 12 | 450 | 10 | 75 | 450 | 1.5 | 77 | 18 | 13 | 2.80 | Yes | B |
| F | 23 | Al-Ni-0.6at%Nd | 12 | 450 | 10 | 75 | 350 | 0.3 | 76 | 23 | 20 | 2.77 | Yes | B |
| | 24 | Al-Ni-0.6at%Nd | 12 | 450 | 10 | 75 | 350 | 1 | 79 | 30 | 10 | 2.98 | No | A |
| | 4 | Al-Ni-0.6at%Nd | 12 | 450 | 10 | 75 | 350 | 1.5 | 80 | 39 | 8 | 3.11 | No | A |
| | 25 | Al-Ni-0.6at%Nd | 12 | 450 | 10 | 75 | 350 | 2 | 79 | 32 | 9 | 3.01 | No | A |
| | 26 | Al-Ni-0.6at%Nd | 12 | 450 | 10 | 75 | 350 | 3 | 78 | 20 | 17 | 2.77 | Yes | B |

From Tables 1 and 2, considerations can be made as follows.

Firstly, Table 1 will be considered. In Table 1, results of the Al-Ni-0.35at%La alloy (content ofNi = 0 to 12 atomic percent) sputtering targets are summarized.

In column A of Table 1, contents ofNi contained in the sputtering targets were variously changed and influences on the deposition rate and generation of the sputtering defects were investigated.

As shown in Table 1, in all examples of Nos. 3 through 5 where the Ni content satisfies the range of the invention, sputtering targets were produced under the conditions specified by the invention; accordingly, predetermined crystallographic orientations were obtained. As the result, even when high-rate deposition was applied, owing to high deposition rate, low sputtering power conditions could be adopted; accordingly, the occurrence frequency of the arching that is likely to occur under high sputtering power condition could be reduced.

On the other hand, in all of an example (example No. 1) that does not contain Ni, an example (example No. 2) that contains only a little Ni and an example (example No. 6) that contains Ni much, although sputtering targets were produced under conditions specified by the invention, predetermined crystallographic orientations could not be obtained, resulting in low deposition rate and occurrence of the sputtering defects.

In column B of Table 1, with the content of Ni kept constant at 2 atomic percent, the rolling temperature was variously varied and influences on the deposition rate and generation of the sputtering defects were investigated.

As shown in Table 1, in all examples of Nos. 8, 4 and 9 where producing conditions including the rolling temperature satisfy the range of the invention, predetermined crystallographic orientations were obtained and desired characteristics were obtained.

On the other hand, in all examples where the rolling temperature is low (example No. 7) and high (example No. 10), predetermined crystallographic orientations could not be obtained, the deposition rate was slow and the sputtering defect was found.

In column C of Table 1, with the content ofNi kept constant at 2 atomic percent, the rolling reduction per one pass was variously varied and influences on the deposition rate and generation of the sputtering defects were investigated.

As shown in Table 1, in all examples of Nos. 12, 4 and 13 where the producing conditions including the rolling reduction per one pass satisfy the ranges of the invention, predetermined crystallographic orientations were obtained and desired characteristics were obtained.

On the other hand, in all examples where the rolling reduction per one pass is low (example No. 11) and high (example No. 14), predetermined crystallographic orientations could not be obtained, the deposition rate was slow and the sputtering defect was found.

In column D of Table 1, with the content ofNi kept constant at 2 atomic percent, the total rolling reduction was variously varied to investigate influences on the deposition rate and the occurrence of the sputtering defects.

As shown in Table 1, in all examples of Nos. 16, 4 and 17 where the producing conditions including the total rolling reduction satisfy the range of the invention, predetermined crystallographic orientations could be obtained and desired characteristics were obtained.

On the other hand, in all examples where the total rolling reduction is low (example No. 15) and high (example No. 18), predetermined crystallographic orientations could not be obtained, the deposition rate was slow and the sputtering defect was found.

In column E of Table 1, with the content ofNi kept constant at 2 atomic percent, the heating temperature (heat treatment temperature) was variously varied to investigate influence on the deposition rate and the generation of the sputtering defect.

As shown in Table 1, in all examples of Nos. 20, 4 and 21 where the producing conditions including the heating temperature satisfy the range of the invention, predetermined crystallographic orientations could be obtained and desired characteristics were obtained.

On the other hand, in all examples where the heating temperature is low (example No. 19) and high (example No. 22), predetermined crystallographic orientations could not be obtained, the deposition rate was slow and the sputtering defect was found.

In column F of Table 1, with the content ofNi kept constant at 2 atomic percent, the heating time (heat treatment time) was variously varied to investigate influence on the deposition rate and the occurrence of the sputtering defects.

As shown in Table 1, in all examples of Nos. 24, 4 and 25 where the producing conditions including the heating time satisfy the range of the invention, predetermined crystallographic orientations could be obtained and desired characteristics were obtained.

On the other hand, in all examples where the heating time is short (example No. 23) and long (example No. 26), predetermined crystallographic orientations could not be obtained, the deposition rate was slow and the sputtering defect was found.

In Table 2, results of Al-Ni-0.6at%Nd alloy (content ofNi = 0 to 12 atomic percent) sputtering targets are shown together. As will be detailed below, tendency similar to Table 1 was found as well when a rare earth element (Nd) other than La was used.

In column A of Table 2, a content ofNi contained in the sputtering target was variously varied to investigate influences on the deposition rate and the generation of the sputtering defect.

As shown in Table 2, in all examples of Nos. 3 through 5 where the Ni content satisfies the range of the invention, sputtering targets were produced under the conditions specified by the invention; accordingly, predetermined crystallographic orientations were obtained. As the result, even when high-rate deposition was applied, owing to high deposition rate, low sputtering power conditions could be adopted; accordingly, the occurrence frequency of the arching that is likely to occur under high sputtering power condition could be reduced.

On the other hand, in all examples where Ni is not contained (example No. 1), Ni is contained only a little (example No. 2) and Ni is contained much (example No. 6), although sputtering targets were produced under conditions specified by the invention, predetermined crystallographic orientations could not be obtained, resulting in low deposition rate and occurrence of the sputtering defects.

In column B of Table 2, with the content ofNi kept constant at 2 atomic percent, the rolling temperature was variously varied and influences on the deposition rate and generation of the sputtering defects were investigated.

As shown in Table 2, in all examples of Nos. 8, 4 and 9 where producing conditions including the rolling temperature satisfy the range of the invention, predetermined crystallographic orientations were obtained and desired characteristics were obtained.

On the other hand, in all examples where the rolling temperature is low (example No. 7) and high (example No. 10), predetermined crystallographic orientations could not be obtained, the deposition rate was slow and the sputtering defect was found.

In column C of Table 2, with a content ofNi kept constant at 2 atomic percent, the rolling reduction per one pass was variously varied and influences on the deposition rate and generation of the sputtering defects were investigated.

As shown in Table 2, in all examples of Nos. 12, 4 and 13 where the producing conditions including the rolling reduction per one pass satisfy the ranges of the invention, predetermined crystallographic orientations were obtained and desired characteristics were obtained.

On the other hand, in examples where the rolling reduction per one pass is low (example No. 11) and high (example No. 14), predetermined crystallographic orientations could not be obtained, the deposition rate was slow and the sputtering defect was found.

In column D of Table 2, with a content ofNi kept constant at 2 atomic percent, the total rolling reduction was variously varied to investigate influence on the deposition rate and the occurrence of the sputtering defects.

As shown in Table 2, in all examples of Nos. 16, 4 and 17 where the producing conditions including the total rolling reduction satisfy the range of the invention, predetermined crystallographic orientations could be obtained and desired characteristics were obtained.

On the other hand, in all examples where the total rolling reduction is low (example No. 15) and high (example No. 18), predetermined crystallographic orientations could not be obtained, the deposition rate was slow and the sputtering defect was found.

In column E of Table 2, with a content ofNi kept constant at 2 atomic percent, the heating temperature (heat treatment temperature) was variously varied to investigate influence on the deposition rate and the generation of the sputtering defect.

As shown in Table 2, in all examples of Nos. 20, 4 and 21 where the producing conditions including the heating temperature satisfy the range of the invention, predetermined crystallographic orientations could be obtained and desired characteristics were obtained.

On the other hand, in all examples where the heating temperature is low (No. 19) and high (No. 22), predetermined crystallographic orientations could not be obtained, the deposition rate was slow and the sputtering defect was found.

In column F of Table 2, with a content ofNi kept constant at 2 atomic percent, the heating time was variously varied to investigate influence on the deposition rate and the occurrence of the sputtering defects.

As shown in Table 2, in all examples of Nos. 24, 4 and 25 where the producing conditions including the heating time satisfy the range of the invention, predetermined crystallographic orientations could be obtained and desired characteristics were obtained.

On the other hand, in all examples where the heating time is short (example No. 23) and long (example No. 26), predetermined crystallographic orientations could not be obtained, the deposition rate was slow and the sputtering defect was found.

While the present invention has been described in detail and with reference to specific embodiments thereof, it will be apparent to one skilled in the art that various changes and modifications can be made therein without departing from the scope thereof.

This application is based on Japanese patent application No. 2006-313505 filed November 20, 2006, the entire contents thereof being hereby incorporated by reference.

Further, all references cited herein are incorporated in their entireties.

**Claims**

1. An Al-based alloy sputtering target, comprising Ni in an amount of 0.05 to 10 atomic percent, wherein the Al-based alloy sputtering target satisfies:

   (1) that a ratio of a P value to a total area of a sputtering surface is 70% or more, wherein the P value indicates a total of area fractions of <001> ± 15°, <011> ± 15°, <111> ± 15° and <311> ± 15°;
   (2) that a ratio of the area fraction of <011> ± 15° to the P value is 30% or more; and
   (3) that a ratio of the area fraction of <111> ± 15° to the P value is 10% or less, when crystallographic orientations <001>, <011>, <111> and <311> in a normal line direction to a sputtering surface of the Al-based alloy sputtering target are observed in accordance with the electron backscatter diffraction pattern method.

2. The Al-based alloy sputtering target according to claim 1, which further comprises a rare earth element in an amount of 0.1 to 2 atomic percent.

3. A process for producing the Al-based alloy sputtering target according to claim 1, comprising:

   preparing a dense body of an Al-based alloy; then
   forging the dense body of Al-based alloy to obtain a slab; then
   rolling the slab under the conditions with a rolling temperature of 400 to 500°C, a rolling reduction per one pass of 5 to 15%, and a total rolling reduction of 60 to 90%; and then
   conducting a heating at a temperature in a range of 300 to 400°C for I to 2 hours.

4. The process according to claim 3, wherein said preparation of the dense body of an Al-based alloy includes:

   producing an Al-based alloy preform in accordance with a spray forming method, and
   densifying the Al-based alloy preform by means of a densifying means.

# FIG. 1

# FIG. 2

RD↑

TD←

Gray Scale Map Type: <none>

Color Coded Map Type: Inverse Pole Figure [001]
Aluminum

111

001    101

Boundaries: <none>

EP 1 932 940 A1

## FIG. 3

RD↑

TD

Gray Scale Map Type: <none>

Color Coded Map Type: Inverse Pole Figure [001]
Aluminum

111

001     101

Boundaries: <none>

EP 1 932 940 A1

# FIG. 4

# FIG. 5

**European Patent Office**

**EUROPEAN SEARCH REPORT**

Application Number

EP 07 02 2151

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | EP 1 700 928 A (KOBE STEEL LTD [JP]; KOBELCO RES INST INC [JP]) 13 September 2006 (2006-09-13) * the whole document * | 1-4 | INV. C23C14/34 C22C21/00 |
| A | US 5 456 815 A (FUKUYO HIDEAKI [JP] ET AL) 10 October 1995 (1995-10-10) * the whole document * | 1-4 | |
| A,D | JP 06 128737 A (MITSUBISHI CHEM IND) 10 May 1994 (1994-05-10) * abstract * | 1-4 | |
| A,D | JP 06 081141 A (MITSUBISHI CHEM IND) 22 March 1994 (1994-03-22) * abstract * | 1-4 | |

TECHNICAL FIELDS SEARCHED (IPC)

C23C
C22C

The present search report has been drawn up for all claims

| Place of search | Date of completion of the search | Examiner |
|---|---|---|
| Munich | 22 January 2008 | Swiatek, Ryszard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 07 02 2151

This annex lists the patent family members relating to the patent documents cited in the above-mentioned European search report.
The members are as contained in the European Patent Office EDP file on
The European Patent Office is in no way liable for these particulars which are merely given for the purpose of information.

22-01-2008

| Patent document cited in search report | | Publication date | Patent family member(s) | | Publication date |
|---|---|---|---|---|---|
| EP 1700928 | A | 13-09-2006 | CN | 1821437 A | 23-08-2006 |
| | | | JP | 2006225687 A | 31-08-2006 |
| | | | KR | 20060092094 A | 22-08-2006 |
| | | | SG | 125196 A1 | 29-09-2006 |
| | | | US | 2006180250 A1 | 17-08-2006 |
| US 5456815 | A | 10-10-1995 | NONE | | |
| JP 6128737 | A | 10-05-1994 | NONE | | |
| JP 6081141 | A | 22-03-1994 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004214606 A
- JP 10147860 A
- JP 10199830 A
- JP 11293454 A
- JP 2001279433 A
- JP 6128737 A

- JP 6081141 A
- JP 2006225687 A
- JP 11315373 A
- JP 00082855 A
- JP 2006073337 A
- JP 2006313505 A